Europäisches Patentamt

European Patent Office

Office européen des brevets

(11) Veröffentlichungsnummer: **0 216 750**
**B1**

(12) **EUROPÄISCHE PATENTSCHRIFT**

(45) Veröffentlichungstag der Patentschrift: **09.05.90**

(51) Int. Cl.⁵: **H 01 J 37/30, G 03 F 1/00**

(21) Anmeldenummer: **86890256.0**

(22) Anmeldetag: **10.09.86**

(54) **Ionenstrahlgerät und Verfahren zur Ausführung von Änderungen, insbesondere Reparaturen an Substraten unter Verwendung eines Ionenstrahlgerätes.**

(30) Priorität: **11.09.85 AT 2661/85**

(43) Veröffentlichungstag der Anmeldung:
**01.04.87 Patentblatt 87/14**

(45) Bekanntmachung des Hinweises auf die
Patenterteilung:
**09.05.90 Patentblatt 90/19**

(84) Benannte Vertragsstaaten:
**AT BE DE FR GB IT NL SE**

(56) Entgegenhaltungen:
**EP-A-0 075 949**
**EP-A-0 108 375**

**APPLIED PHYSICS LETTERS, Band 34, Nr. 5, 1. März 1979, Seiten 310-312, American Institute of Physics, New York, US; R.L. SELIGER et al.: "A high-intensity scanning ion probe with submicrometer spot size"**

(73) Patentinhaber: **IMS Ionen Mikrofabrikations Systeme Gesellschaft m.b.H.**
**Schreygasse 3**
**A-1020 Wien (AT)**
(73) Patentinhaber: **Österreichische Investitionskredit Aktiengesellschaft**
**Renngasse 10**
**A-1013 Wien (AT)**

(72) Erfinder: **Stengl, Gerhard, Dr.**
**Hammergasse 11**
**A-9500 Villach Kärnten (AT)**
Erfinder: **Löschner, Hans, Dr.**
**Vegagasse 6/2**
**A-1190 Wien (AT)**

(74) Vertreter: **Casati, Wilhelm, Dipl.-Ing. et al**
**Patentanwälte Casati, Wilhelm, Dipl.-Ing. Krause, Ernst, Dipl.-Ing. Itze, Peter, Dipl.-Ing.**
**Amerlingstrasse 8**
**A-1061 Wien (AT)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Ionenstrahlgerät mit einer Ionenquelle, einer dieser nachgeschalteten im Strahlengang angeordneten Linse zur Ionenbeschleunigung und einer der Linse nachgeschalteten Ablenkeinrichtung für die Ionen, wobei im Bereich zwischen der Ionenquelle und der nachgeschalteten Linse eine mit einer Öffnung versehene Maske angeordnet ist und diese Öffnung durch eine ionenoptische Einrichtung verkleinert auf ein Substrat abbildbar ist, und zwischen der Ionenquelle und der mit der Öffnung versehenen Maske eine steuerbare Linse zur Änderung des Winkels ε, unter dem die Ionen aus der Ionenquelle austreten, angeordnet ist.

Bei der Fertigung von integrierten Schaltungen werden Strukturen, die in einer Maske enthalten sind, nach den Methoden der Lithographie auf ein beschichtetes Halbleitersubstrat übertragen. Geht man davon aus, daß im Bereich von Submikrometerstrukturen, und hier insbesondere im Bereich 0,2 µm bis 0,7 µm, die Röntgenstrahllithographie mit Synchrotronstrahlung als die aussichtsreichste Übertragungstechnik erscheint, so ist es aufgrund der Übertragungstechnik, die im Maßstab 1:1 arbeitet, erforderlich, Masken mit besonders hoher Stabilität und Maßhaltigkeit zur Verfügung zu haben. Durch spezielle Herstellungstechniken erscheinen die hohen Anforderungen auch bezüglich der Einhaltung von Toleranzen der Linienbreite erfüllbar. Die Herstellung von Masken ist allerdings nicht völlig defektfrei möglich und auch bei der Lagerung und dem Einsatz der Masken können Defekte auf die Röntgenstrahlmaske gelangen. Bei Röntgenstrahlmasken treten vor allem drei Arten von Defekten auf, nämlich

a) Pinholes, bzw. Fehlen von Absorbermaterial in Strukturelementen,

b) röntgenlichtundurchlässige Oberflächendefekte, bzw. Überschuß von Absorbermaterial an oder zwischen Strukturelementen,

c) Defekte in der Trägerfolie (z.B. bei BN-Folien restliches Silizium)

## Stand der Technik

Der derzeitige Entwicklungsstand erlaubt durch Kombination von laserinduzierter Abscheidung, Defekte wie sie vorstehend unter (a) erwähnt sind, abzudecken und Defekte der unter (b) genannten Art durch Wegsputtern zu entfernen, welche Methode auch für das Nacharbeiten von Defekten gemäß (a) anwendbar ist. Defekte der unter (c) genannten Type sind von geringer Bedeutung für den Übertragungsprozeß mit Röntgenstrahlen, vor allem wenn als Trägermaterial für die Folie Silizium verwendet wird. Vor Ausführung der Reparaturen müssen die zu reparierenden Stellen aufgefunden werden, wobei auch die Art des Defektes zu charakterisieren ist. Hiefür existieren bereits geeignete, auf optischer Mikroskopie bzw. Elektronenmikroskopie beruhende Inspektionsgeräte, die als Ergebnis der vorgenannten Inspektion, bei der die zu prüfende Maske mit einem Original oder einer Datenbasis verglichen wird, Ortskoordinaten der Defekte liefern, und auch die Art der an diesen Orten eruierten Defekte angeben.

Um nun einen Defekt der Maske reparieren zu können, ist es erforderlich, zunächst den Ort des Defektes, der vom Inspektionsgerät festgestellt wurde, wieder aufzufinden und dann den Defekt zu behandeln. Zu diesem Zweck wurden schon Ionenstrahlgeräte der eingangs erwähnten Art eingesetzt. Solche Geräte sind etwa in der EP-OS 0 075 949 (H. Yamaguchi et al) beschrieben. Diese Geräte sind mit einem Multipol als Ablenkeinrichtung für die Ionen und mit einer variablen Öffnung in der Maske versehen, wobei diese Öffnung auch kreisförmig gestaltet sein kann.

Bei den bekannten Geräten werden Flüssigmetallionenquellen verwendet, wobei die Ionenquelle z.B. im Maßstab 1:1 ionenoptisch auf das Substrat abgebildet wird. Mit solchen Geräten kann eine für eine Reparatur ausreichende Ionenstromdichte von etwa 1 A/cm² am Substrat erreicht werden. Die Intensität eines Ionenstrahls ist allerdings kurzzeitig unregulierbar. Nachteilig ist dabei, daß das Auffinden des zu reparierenden Defektes sehr rasch erfolgen muß, widrigenfalls der zum Orten des Defektes dienende Ionenstrahl defektfreie Zonen zerstört oder zumindest beschädigt. Die Notwendigkeit, das Orten der zu reparierenden Stelle möglichst rasch auszuführen, geht dabei auf Kosten der Genauigkeit, die insbesondere bei der Reparatur von Rontgenstrahlmasken besonders hohe Anforderungen erreicht.

Ionenstrahlgeräte, welche Maskenstrukturen verkleinert abbilden können, sind z.B. aus der DE-PS 1 615 187 bekannt bzw. auch in J.Vac.Sci & Technol 16 (6) 1883 (1979, G.Stengl et al) beschrieben. Ein derartiges Ionenstrahlgerät kann vor der nachgeschalteten Linse mit einer Maske versehen sein, welche eine gegebenenfalls variable Öffnung aufweist, die durch eine ionenoptische Einrichtung verkleinert auf ein Substrat abbildbar ist.

## Darstellung der Erfindung

Der Erfindung liegt die Aufgabe zugrunde, ein Ionenstrahlgerät der eingangs erwähnten Art, das einen insbes. fokussierten Ionenstrahl liefert, so auszugestalten, daß ein Mikroskopiebetrieb zum Auffinden der Defekte ermöglicht wird, bei dem der Ionenstrahl über praktisch beliebig lange Zeit auf das Substrat einwirken kann, ohne Gefahr, daß das Ionenstrahlgerät zusätzliche Defekte generiert, oder Strukturen in unzulässigem Ausmaß durch Erwärmung oder Ionensputterwirkung verändert werden und hernach den Defekt zu beheben.

Erreicht wird dies mit einem Ionenstrahlgerät der eingangs erwähnten Art, wenn erfindungsgemäß die Linse den Strahlquerschnitt an der Maske soverändert, daß, abhängig von der Erregung der Linse, unterschiedliche Anteile des von der Ionenquelle emittierten Ionenflusses die Öffnung passieren können, so daß für die Mikroskopiephase ein geringer Strahlstrom und für die Bearbeitungsphase ein hoher Strahlstrom erreicht werden kann, wobei der Ionenstrahl jeweils divergent auf die Maske auftrifft. Bei Anwendung des erfindungsgemäß ausgestalteten Gerätes wird in der Arbeitsweise als Mikroskop, also beim Aufsuchen des Ortes eines Defektes, die Öffnung der Maske auf das Substrat durch eine ionenoptische Einrichtung verkleinert abgebildet. Veränderungen der Ionenquelle bzw. Schwankungen des Ortes der Ionenquelle haben auf die Abbildung lediglich einen vernachlässigbar kleinen Einfluß, da nicht die Ionenquelle, sondern die Öffnung der Maske verkleinert auf das Substrat abgebildet wird. Die Ionenquelle ist daher vom weiteren Geschehen weitgehend entkoppelt. Dadurch wird es möglich, bei dem hier interessierenden Submikrometerbereich (wie er für eine Betrachtung von Röntgenstrahlmasken etwa erforderlich ist), in dem die Defekte liegen, die Öffnung in der Maske trotzdem relativ groß auszubilden (z.B. 1 µm Durchmesser), da bei einem Abbildungsmaßstab 1 : n ein n-fach kleineren Ionenstrahl auf das Substrat trifft. Als Ionenquelle wird bevorzugt eine Duoplasmatronionenquelle eingesetzt, die eine Stromdichte an der Maske von etwa 10 µA/cm² erlaubt. Die Ionen können Wasserstoff-, Helium-, Argon- oder Xenonionen sein. Vorzugsweise besitzt die Anode einer Duoplasmatronionenquelle eine Öffnung von 250 µm Durchmesser, wobei die Saugelektrode 0,5 mm unter der Anode angeordnet ist und eine etwas größere Öffnung als die Anode aufweist. Der Winkel des Ionenstrahles beträgt 4° und der Ionenstrom ist je nach Art der Ionen mehr als 200 µA. Durch die besondere Ausgestaltung der Ionenquelle ist es möglich, einen weitgehend laminaren Ionenstrom durch die Anodenöffnung zu erzeugen, wodurch eine Größe der virtuellen Ionenquelle unter 50 µm erzeugt wird. Ein weiterer Vorteil der Duoplasmatronionenquelle besteht darin, daß der Ionenstrom etwa um einen Faktor 5 vermindert werden kann, ohne die Größe der virtuellen Ionenquelle wesentlich zu ändern. Dadurch kann die Mikroskopie zur Auffindung der Defektbereiche mit einem Ionenstrahl besonders niedriger Intensität ausgeführt werden, so daß keine Gefahr besteht, Defekte zusätzlich zu generieren. Die Ionenenergie an der Maske beträgt bevorzugt 5—10 keV. Durch die erfindungsgemäß vorgesehene steuerbare (zu- und abschaltbare) Linse ist es möglich, in einfacher Weise die Intensität des Ionenstrahles zu verändern. Durch Verkleinern des Winkels wird hiebei eine Intensitätssteigerung in Höhe des Quadrates des Verkleinerungsfaktors des Winkels erzielt. So bringt eine — durchaus mögliche — Verkleinerung auf 1/6, eine Intensitätssteigerung auf das 36-fache. Solcherart kann daher der Anwendungsbereich des Ionenstrahlgerätes vom Mikroskopiebetrieb auf Reparaturbetrieb — einfach durch Intensitätssteigerung des Ionenstrahles — erweitert werden. Das Zu- und Abschalten der Linse kann dabei ausreichend schnell erfolgen. Schaltzeiten im µsec-Bereich sind möglich. Somit kann das Gerät

als fokussierte Ionen-Reparatureinrichtung eingesetzt werden. Basis für diesen Einsatz ist ein in der Intensität über mehrere Größenordnungen durchstimmbarer fokussierter Ionenstrahl, wobei mit niedriger Intensität in der Mikroskopie-Mode das Auffinden von (durch eine Inspektionseinrichtung) registrierten Defekten erfolgt und mit hoher Intensität die Defekte exakt repariert werden können, da zwischen Mikroskopie-Mode und Reparatur-Mode die Ortsinformation des Ionenstrahls am Substrat erhalten bleibt. Je enger jedoch der Strahl wird, umso größer wird der Durchmesser der virtuellen Ionenquelle. Die Winkeländerung ist daher in einem solchen Ausmaß zu halten, daß sich der Ionenstrahl am Substrat in seinem Durchmesser nur um einen tolerierbaren Wert ändert. Für die Mikroskopie-Mode wird man dabei den größten Winkel (typisch 4°) nehmen.

Veränderungen, insbes. Reparaturen an Substraten, können unter Verwendung eines erfindungsgemäßen Ionenstrahlgerätes so ausgeführt werden, daß erfindungsgemäß nach Feststellung des zu reparierenden Bereiches des Substrates, in der Mikroskopie-Mode, innerhalb eines Arbeitsbereiches ein Reparaturbereich festgelegt wird, und der Arbeitsbereich mit dem Ionenstrahl abgescannt wird, wobei jedoch bei Eintritt des Ionenstrahls in den Reparaturbereich die Intensität des Ionenstrahles (durch Aktivieren der steuerbaren Linse) erhöht und bei Austritt aus dem Reparaturbereich wieder vermindert wird und das Scannen mittels des nunmehr geringere Intensität aufweisenden Ionenstrahls über den Arbeitsbereich fortgesetzt wird. Zur Effektivitätssteigerung des erfindungsgemäßen Ionenstrahlgerätes kann der Mikroskopie-Betrieb mit leichten Ionen (H⁺ oder He⁺) und der Reparatur-Betrieb mit schwereren Ionen (Ar⁺ oder Xe⁺) durchgeführt werden. Das Umschalten zwischen den Ionen-Arten erfolgt entweder durch Wechsel der Gassorte, oder aber es wird die Ionenquelle mit einem Gasgemisch (z.B. Wasserstoff und Argon) gespeist, aus welchem durch einen nachgeschalteten Massenanalysator die gewünschte Ionenart herausgefiltert wird.

Die Zustellgenauigkeit des Ionenstrahls ist unter dem Blickwinkel festzusetzen, daß der Ionenstrahl selbst keine Defekte auf dem zu reparierenden Substrat (Röntgenstrahlmaske) verursachen darf. Die Zustellgenauigkeit muß an der kleinsten Linienbreite der zu reparierenden Maske gemessen werden und sollte besser als die zulässige maximale Variation dieser Linienbreite sein. Beträgt diese maximale Variation der Linienbreite 20% so ist eine Zustellgenauigkeit von 0,1 µm für die Reparatur von Masken mit 0,5 µm Design notwendig, bzw. von 0,04 µm für Masken mit 0,2 µm Design. Somit ist der zulässige Wert der zeitlichen Drift des Ionenstrahles gering zu halten und ist auch an die Reparaturzeit gekoppelt. Eine zeitliche Drift des Ionenstrahles unter 0,1 µm für eine Reparaturzeit von 100 sec kann für das erfindungsgemäße Verfahren eingehalten werden.

Bei Anwendung des erfindungsgemäßen Reparaturverfahrens ist eine Überlagerung von Reparatur und Mikroskopie möglich, d.h. es wird eine Echtzeitreparatur der Defekte ausgeführt. Auch während der Reparatur kann die Reparaturarbeit beobachtet werden, so daß laufend feststellbar ist, ob die Reparatur an der richtigen Stelle erfolgt und ausreichend ist.

Kurze Beschreibung der Zeichnung

Die Erfindung wird nachstehend aufgrund der Zeichnung beispielsweise erläutert. Es zeigen:

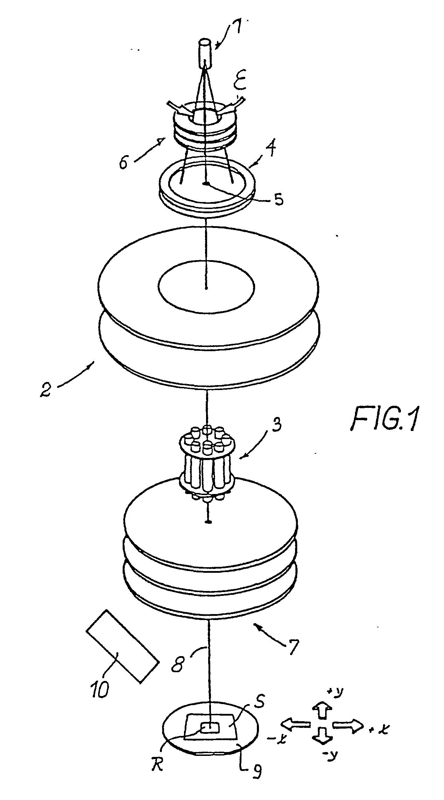

Fig. 1 ein erfindungsgemäßes Ionenstrahlgerät im Schema, und die

Fig. 2 bis 4 ein Substrat in vergrößertem Maßstab mit einem Defekt, der mittels eines erfindungsgemäß ausgestatteten Ionenstrahlgerätes repariert werden kann.

In der Zeichnung ist mit 1 eine Ionenquelle bezeichnet, der — im Strahlengang liegend — eine Immersionslinse 2 nachgeschaltet ist. Dieser Immersionslinse nachgeschaltet ist eine Ablenkeinrichtung für die Ionen, die im dargestellten Ausführungsbeispiel von einem Oktopol gebildet ist, d.s. 8 Stäbe, die zur Ablenkung des Strahles an Spannung gelegt werden können. Auch auf magnetischer Basis arbeitende Ablenkeinrichtungen kommen in Frage. Im Bereich zwischen der Ionenquelle 1 und der Immersionsquelle 2 ist eine Maske 4 angeordnet, die zumindest eine Öffnung 5 aufweist. Bevorzugt wird die Öffnung 5 kreisrund ausgeführt.

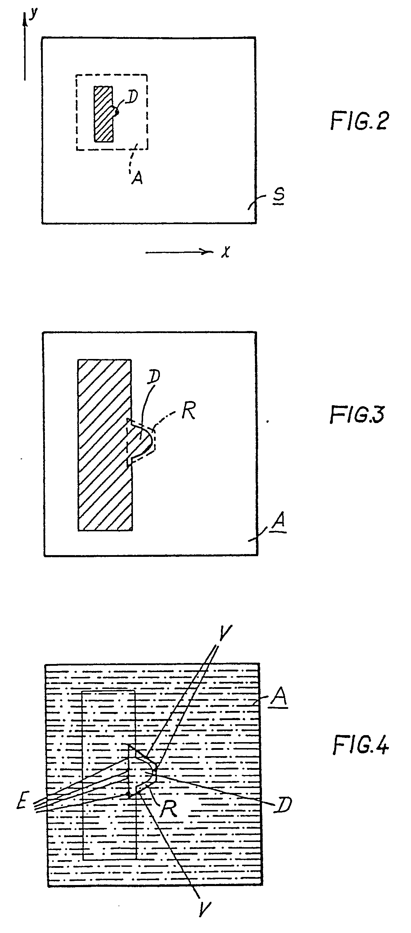

Die Größe der Öffnung kann auch (ähnlich wie bei einer Kamera) variabel gestaltet werden. Der aus der Ionenquelle 1, die bevorzugt als Duoplasmatronionenquelle ausgebildet ist, kommende Ionenstrahl beleuchtet divergent (Winkel ε z.B. 4°) die Maske 4 mit einer Ionenenergie von 5—10 keV. Die Immersionslinse 2 beschleunigt die durch die Öffnung 5 tretenden Ionen auf eine Endenergie von beispielsweise 60—90 keV am Substrat S, das z.B. eine zu reparierende Röntgenstrahlmaske sein kann. Als Ionen werden bevorzugt Wasserstoff- oder Helium- oder Argon- oder Xenonionen eingesetzt. Zwischen der Ablenkeinrichtung 3 und dem Substrat S ist ein verkleinerndes Projektionslinsensystem 7 angeordnet. Die Anordnung im Ionenstrahlgerät ist so getroffen, daß auf das Substrat S ein Einzelstrahl 8 auftrifft. Das Projektionslinsensyssstem 7 dient zur Erzeugung eines Bildes der Maske 4 bzw. von deren Durchbrechung 5 in einer Verkleinerung 1:n. Bevorzugt wird n mit 10 gewählt, jedoch kann n auch bis 30 ansteigen. Um die Intensität des Ionenstrahles steuern zu können, ist zwischen der Maske 4 und der Ionenquelle 1 eine steuerbare Linse 6 angeordnet, welche, wie in der Zeichnung angedeutet, als Einzel-Linse ausgeführt sein kann. Durch Verengen des Strahles wird eine Intensitätssteigerung im Ausmaß des Quadrates des Verringerungsverhältnisses erreicht. Wird z.B. der Strahl auf l/6 seines ursprünglichen Winkels zusammengedrückt, was bei einem ursprünglichen Strahldurchmesser von ausführbaren 3 cm eine Verengung auf ca. 5 mm Durchmesser bedeutet, so steigt die Intensität des Strahles, der das Loch in der Maske durchsetzt, auf das 36-fache des ursprünglichen Wertes. Ein derart intensiver Strahl kann zu Reparaturzwecken eingesetzt werden. Das Substrat S liegt auf einem Tisch 9, der in zwei zueinander senkrechten Richtungen x, y verschoben und gegebenenfalls auch gedreht werden kann. Mit einem Ionenstrahlgerät, das mit einer Maske 4 und einer steuerbaren Linse 6 ausgestattet ist, kann bei ausgeschalteter Linse in Mikroskopie-Mode gearbeitet und dabei ein Defekt auf dem Substrat annähernd in den Bereich der ionenoptischen Achse durch entsprechende Bewegung des Tisches gebracht werden, worauf dann das Abtasten des Defektbereiches durch entsprechendes Ablenken des Ionenstrahles durch Aktivieren der Ablenkeinrichtung 3 erfolgt. Mit Hilfe des über die Detektoreinheit 10 gewonnenen Sekundärelektronen- oder Sekundärionensignals, kann der mit Hilfe der Ablenkeinrichtung 3 durch den Ionenstrahl 8 abgescannte Substratbereich S (Fig. 2) am Bildschirm sichtbar gemacht werden. Durch Bewegung des Tisches 9 wird der Defektbereich D ungefähr in die ionenoptische Achse geschoben, so daß mit zusätzlicher Vergrößerung des Bildes ein Arbeitsbereich A (Fig. 3) sichtbar wird. Dieser kann so groß gemacht werden, daß der Einzelionenstrahl in diesem Bereich eine bestimmte Größe nicht überschreitet, während zum Aufsuchen des Defektbereiches D ein stärker abgelenkter Strahl möglich ist (größerer Scannbereich). Durch Operationseingabe (z.B. Leuchtgriffel) kann dann ein entsprechender Reparaturbereich R (x, y) z.B. Trapez in Fig. 3 festgelegt werden. Der Ionenstrahl wird dann Zeile für Zeile (Strich-Punkt Linien) über den Arbeitsbereich A geführt (Fig. 4) und zwar so, daß er in jeder Richtung den Reparaturbereich R überschreitet. Der Arbeitsbereich bleibt während des Scannens auf dem Bildschirm sichtbar. Sobald der Strahl bei Bewegung in den Reparaturbereich R eintritt (Punkt E), wird die steuerbare Linse 6 aktiviert. Sobald der Strahl den Reparaturbereich verläßt (Punkt V), wird die Linse 6 in den inaktiven Zustand versetzt, der Strahl wird mit geringer Intensität weitergescannt, wobei das Bild des Arbeitsbereiches A (und des Reparaturbereiches R) sichtbar bleibt. Solcherart hat man, auch während das Gerät in der Reparatur-Mode arbeitet, das Bild vor sich und damit sofortige Kontrolle der Reparatur. Es wird auf diese Weise eine "Real-time" Bearbeitung erzielt, wobei lediglich in der Zeit, in der der Strahl den Reparaturbereich R überstreicht, das Bild entsprechend der erhöhten Intensität des Strahles heller ist. Es ist jedoch auch möglich, während der Arbeit des Gerätes in der Reparatur-Mode, das Detektorsignal, während sich der Strahl im Reparaturbereich R befindet, so abzuschwächen, daß über den gescannten Arbeitsbereich eine weitgehend einheitliche Bildhelligkeit erzielt wird. Schließlich kann die geleistete Reparaturarbeit kontrolliert werden, indem das Gerät wieder in der Mikroskopiemode betrieben wird. Erforderlichenfalls kann dann wieder erneut in der vorstehend beschriebenen Weise repariert werden.

**Patentansprüche**

1. Ionenstrahlgerät mit einer Ionenquelle (1), einer dieser nachgeschalteten im Strahlengang angeordneten Linse (2) zur Ionenbeschleunigung und einer der Linse (2) nachgeschalteten Ablenkeinrichtung (3) für die Ionen, wobei im Bereich zwischen der Ionenquelle (1) und der nachgeschalteten Linse (2) eine mit einer Öffnung (5) versehene Maske (4) angeordnet ist und diese Öffnung (5) durch eine ionenoptische Einrichtung verkleinert auf ein Substrat (5) abbildbar ist und zwischen der Ionenquelle (1) und der mit der Öffnung (5) versehenen Maske (4) eine steuerbare Linse (6) zur Änderung des Winkels (ε), unter dem die Ionen aus der Ionenquelle (1) austreten, angeordnet ist, dadurch gekennzeichnet, daß die Linse (6) den Strahlquerschnitt an der Maske (4) so verändert, daß, abhängig von der Erregung der Linse (6), unterschiedliche Anteile des von der Ionenquelle (1) emittierten Ionenflusses die Öffnung (5) passieren können, so daß für die Mikroskopiephase ein geringer Strahlstrom und für die Bearbeitungsphase ein hoher Strahlstrom erreicht werden kann, wobei der Ionenstrahl jeweils divergent auf die Maske auftrifft.

2. Ionenstrahlgerät nach Anspruch 1, dadurch gekennzeichnet, daß die Ablenkeinrichtung (3) für die Ionen als Multi-, insbesondere Oktopol ausgebildet ist.

3. Ionenstrahlgerät nach Anspruch 1 oder 2, dadurch gekennzeichnet, daß die Öffnung (5) der Maske (4) variabel ausgebildet ist.

4. Ionenstrahlgerät nach einem der Ansprüche 1 bis 3, dadurch gekennzeichnet, daß die Öffnung (5) der Maske (4) kreisförmig ausgebildet ist.

5. Ionenstrahlgerät nach Anspruch 1, dadurch gekennzeichnet, daß die Ionenquelle (1) als Duoplasmatronionenquelle ausgebildet ist.

6. Verfahren zur Ausführung von Veränderungen z.B. Reparaturen an Substraten, wie Masken, insbesondere Röntgenstrahlmasken, Chips, Schaltkreisen auf Wafern u.dgl., unter Verwendung eines Ionenstrahlgerätes nach einem der Ansprüche 1 bis 5, dadurch gekennzeichnet, daß nach Feststellung des zu reparierenden Bereiches des Substrates (S), innerhalb eines Arbeitsbereiches (A), ein Reparaturbereich (R) festgelegt wird, daß der Arbeitsbereich (A) mit dem Ionenstrahl abgescannt wird, wobei jeweils bei Eintritt des Ionenstrahls in den Reparaturbereich (R), die Intensität des Ionenstrahlles (durch Aktivieren der steuerbaren Linse) erhöht und bei Austritt aus dem Reparaturbereich (R) wieder vermindert wird und das Scannen mittels des nunmehr geringere Intensität aufweisenden Ionenstrahls über den Arbeitsbereich (A) fortgesetzt wird.

**Revendications**

1. Appareil à faisceau ionique comportant une source ionique (1), une lentille (2) placée en aval de celle-ci, sur le parcours du faisceau, pour accélérer les ions et un dispositif de déviation (3) des ions, monté en aval de la lentille (2), un masque (4) pourvu d'une ouverture (5) étant placé dans la zone comprise entre la source ionique (1) et la lentille (2) montée en aval, et cette ouverture (5) pouvant être reproduite sur un substrat (5) réduite par un dispositif optique à ions, et une lentille (6) commandée étant placée entre la source ionique (1) et le masque (4) pourvu de l'ouverture (5) pour modifier l'angle (ε) sous lequel les ions sortent de la source ionique (1), caractérisé en ce que la lentille (6) modifie la section transversale du faisceau sur le masque (4), de manière qu'en fonction de l'excitation de la lentille (6), des proportions différentes du flux ionique émis par la source ionique (1) traversent l'ouverture (5), de sorte que pour la phase de microscopie on peut obtenir un courant de faisceau réduit, et pour la phase de traitement un courant de faisceau élevé, le faisceau ionique arrivant toujours de manière divergente sur le masque.

2. Appareil à faisceau ionique selon la revendication 1, caractérisé en ce que le dispositif de déviation (3) des ions est multipolaire, en particulier octopolaire.

3. Appareil à faisceau ionique selon la revendication 1 ou 2, caractérisé en ce que l'ouverture (5) du masque est variable.

4. Appareil à faisceau ionique selon l'une des revendications 1 à 3, caractérisé en ce que l'ouverture (5) du masque (4) est circulaire.

5. Appareil à faisceau ionique selon la revendication 1, caractérisé en ce que la source ionique (1) est une source duoplasmatron.

6. Procédé de réalisation de modifications, par exemple de réparations sur des substrats, tels que des masques, en particulier des masques pour rayons X, des microplaquettes, des circuits électriques sur tranches de silicium, etc., par utilisation d'un appareil à faisceau ionique selon l'une des revendications 1 à 5, caractérisé en ce qu'après avoir fixé la zone à réparer du substrat (S), on fixe à l'intérieur d'une zone de travail (A), une zone de réparation (R), en ce qu'on balaye la zone de travail (R) avec le faisceau ionique, l'intensité du faisceau ionique étant augmentée (par activation de la lentille commandée) à chaque entrée du faisceau ionique dans la zone de réparation (R), et à nouveau réduite à la sortie de la zone de réparation (R), et en ce qu'on poursuit le balayage au moyen du faisceau ionique présentant maintenant une intensité réduite, sur la zone de travail (A).

**Claims**

1. Ion beam apparatus with an ion source (1), a lens (2) for accelerating the ions arranged behind it in the direction of the beam and a deflection device (3) for the ions arranged behind the lens (2), a mask (4) provided with an opening (5) being arranged in the region between the ion source (1) and the lens (2) behind it and this opening (5) being imagable in a reduced size on a substrate (5) by an ion-optical device and a controllable lens (6) for altering the angle (ε), at which the ions leave the ion source (1), being arranged between the ion source (1) and the mask (4) provided with the opening (5), characterised in that the lens (6) so alters the beam cross section at the mask (4) that, depending on the excitation of the lens (6), differing proportions of the ion flow emitted from the ion source (1) can pass through the opening (5) so that a smaller ion flow can be achieved for the microscopy phase and a higher ion flow can be achieved for the operating phase, the ion beam impinging divergently on the mask in each case.

2. Ion beam apparatus as claimed in claim 1, characterised in that the deflection device (3) for the ions is constructed as a multipole, particularly an octopole.

3. Ion beam apparatus as claimed in claim 1 or 2, characterised in that the opening (5) in the mask (4) is constructed to be variable.

4. Ion beam apparatus as claimed in one of claims 1 to 3, characterised in that the opening (5) in the mask (4) is constructed of circular shape.

5. Ion beam apparatus claimed in claim 1, characterised in that the ion source (1) is constructed as a duoplasmatron ion source.

6. Method of performing alterations eg. repairs to substrates such as masks particularly x-ray masks, chips, switching networks on wafers and the like using an ion beam apparatus as claimed in one of claims 1 to 5, characterised in that after determining the region of the substrate (S) to be repaired within a working region (A), a repair region (R) is defined, that the working region (A) is scanned with the ion beam whereby on entry of the ion beam into the repair region (R) the intensity of the ion beam is increased (by activating the controllable lens) and on exit from the repair region (R) is reduced again and that the scanning is continued over the working region (A) by means of the ion beam which now has a lesser intensity.

FIG.1

FIG.2

FIG.3

FIG.4